# EUROPEAN PATENT APPLICATION

(11) **EP 2 908 254 A1**
(43) Date of publication of application: **19.08.2015**
(21) Application number: 13845224.8
(22) Date of filing: 10.09.2013
(51) Int. Cl.: G06F 17/30

(54) **DATA REDUNDANCY IMPLEMENTATION METHOD AND DEVICE**

(30) Priority: 11.10.2012 CN 201210384091
(71) Applicant: ZTE Corporation, Shenzhen, Guangdong 518057 (CN)
(72) Inventor: YIN, Dan, Shenzhen, Guangdong Province 518057 (CN); ZHAO, Cheng, Shenzhen, Guangdong Province 518057 (CN)
(74) Representative: Novagraaf Technologies
(86) International application number: PCT/CN2013/083249
(87) International publication number: WO 2014/056381

(57) **Abstract**

Provided are a method and device for implementing data redundancy. The method includes: a storage strategy identifier of data to be stored is acquired; and the data to be stored is stored in a storage manner corresponding to the storage strategy identifier, wherein the storage strategy identifier is used for indicating the data to be stored is stored in at least one of the following storage manners: a copy redundancy processing manner and an eraser encoding and decoding processing manner. The problem of incapability of ensuring a higher storage space utilization rate in the related art is solved, so that the security and reliability of the data are ensured, meanwhile, the utilization rate of a storage space is increased, and data redundancy implementation flexibility is improved.

## Description

### Technical Field

The present invention relates to the field of communications, and in particular to a method and device for implementing data redundancy.

### Background

In a Distributed File System (DFS), external storage and local storage equipment is used in a large scale. If there is no additional data redundancy scheme adopted in a storage system, each additional node may cause the degradation of security performance of the whole system. Along with the expansion of capacity, the system becomes less and less secure and even almost unavailable. In order to ensure the security of data and the system, it is necessary to adopt the data redundancy scheme to protect the data and ensure that a certain number of failing nodes are recovered by virtue of redundant data to ensure the security of the data after the nodes fail and lose data. In the information age, the storage of massive data makes a storage space become a necessary resource. At preset, most of DFSs adopt a complete replication redundancy manner, and such a manner may provide service as long as one replication is secure, but has the shortcoming of lower storage space utilization rate. A conventional data redundancy technology cannot ensure a higher storage space utilization rate. Therefore, a novel data redundancy strategy for the file distributed system is needed to ensure the reliability of the data and increase the utilization rate of the storage space according to a requirement of a storage environment and an actual condition.

For at least one of the problems in a related art, there is yet no effective solution.

### Summary

The embodiments of the present invention provides a method and device for implementing data redundancy, so as to solve the problem of incapability of ensuring a higher storage space utilization rate in the related art.

According to one aspect of the embodiment of the present invention, a method for implementing data redundancy is provided, which includes: acquiring a storage strategy identifier of data to be stored; and storing the data to be stored in a storage manner corresponding to the storage strategy identifier, wherein the storage strategy identifier is used for indicating to store the data to be stored in at least one of the following storage manners: a replication redundancy processing manner and an erasure encoding and decoding processing manner.

Preferably, storing the data to be stored in the erasure encoding and decoding processing storage manner includes: acquiring encoding ratio information, which is for encoding the data to be stored with Erasure Code (EC), from a File Location Register (FLR), wherein the encoding ratio information includes: the number N of chunks obtained by dividing the data of each page of the data to be stored and the number M of redundant chunks obtained after the encoding of the chunks of each page, and N and M are natural numbers; dividing the data of each page of the data to be stored into the N chunks according to the encoding ratio information and a size of the data to be stored, performing erasure coding on the N chunks as a group, and generating M redundant chunks for each group; and under the condition that the encoding of all the chunks of a certain page is finished, storing the encoded chunks of the page into a database.

Preferably, storing the encoded chunks of the page into the database includes: transmitting a request message of applying for N+M storage nodes to the database; receiving a reply message in response to the request message, wherein the reply message includes: node information of the N+M storage nodes and location information of the N+M storage nodes; and storing the N+M chunks obtained after the encoding of the chunks of each page into the N+M applied storage nodes according to the node information and the location information respectively.

Preferably, storing the N+M chunks obtained after the encoding of the chunks of each page into the N+M applied storage nodes according to the node information and the location information respectively includes: under the condition that more than M chunks in the encoded chunks of each page are detected to fail to be stored, transmitting a storage failure alarm or notice.

Preferably, storing the N+M chunks obtained after the encoding of the chunks of each page into the N+M applied storage nodes according to the node information and the location information respectively includes: under the condition that at most M chunks in the encoded chunks of each page are detected to fail to be stored, restoring the chunks failing to be stored into the storage nodes corresponding to the chunks failing to be stored, or restoring the chunks failing to be stored into newly-applied storage nodes.

Preferably, after storing the data to be stored in the storage manner corresponding to the storage strategy identifier, the method for implementing data redundancy further includes: acquiring reading information of data to be read, wherein the reading information includes: a storage strategy identifier of the data to be read; and reading data to be read in a corresponding reading manner according to the storage strategy identifier of the data to be read, wherein the storage strategy identifier of the data to be read is used for indicating that the data to be read is stored in at least one of the following storage manners: the replication redundancy processing manner and the erasure encoding and decoding processing manner.

Preferably, reading the data to be read in the corresponding reading manner according to the storage strategy identifier of the data to be read includes: under the condition that the storage manner for the data to be read adopts the erasure encoding and decoding processing manner, acquiring storage information corresponding to N+M encoded chunks of each page of the data to be read, wherein the storage information includes: storage node information of N+M storage nodes and location information of the N+M storage nodes, and N and M are natural numbers; reading the N+M encoded chunks of each page from the N+M storage nodes according to the storage information; and sequentially selecting N chunks from the N+M read chunks for EC decoding, and performing recovery to obtain the data of each page.

According to the other aspect of the embodiment of the present invention, a device for implementing data redundancy is provided, which includes: a first acquisition component configured to acquire a storage strategy identifier of data to be stored; and a storage component configured to store the data to be stored in a storage manner corresponding to the storage strategy identifier, wherein the storage strategy identifier is used for indicating to store the data to be stored in at least one of the following storage manners: a replication redundancy processing manner and an erasure encoding and decoding processing manner.

Preferably, the storage component includes: an acquisition element configured to acquire encoding ratio information, which is for encoding the data to be stored with EC, from an FLR, wherein the encoding ratio information includes: the number N of chunks obtained by dividing the data of each page of the data to be stored and the number M of redundant chunks obtained after the encoding of the chunks of each page, and N and M are natural numbers; an encoding element, configured to divide the data of each page of the data to be stored into the N chunks according to the encoding ratio information and a size of the data to be stored, perform EC encoding on the N chunks as a group, and generate M redundant chunks for each group; and a storage element configured to, under the condition that the encoding of all the chunks of a certain page is finished, store the encoded chunks of the page into a database.

Preferably, the device for implementing data redundancy further includes: a second acquisition component, configured to acquire reading information of data to be read, wherein the reading information includes: a storage strategy identifier of the data to be read; and a reading component, configured to read the data to be read in a corresponding reading manner according to the storage strategy identifier of the data to be read, wherein the storage strategy identifier of the data to be read is used for indicating the data to be read is stored in the at least one of following storage manners: the replication redundancy processing manner and the erasure encoding and decoding processing manner.

According to the embodiment of the present invention, the storage strategy identifier of the data to be stored is acquired at first, and is used for indicating to store the data to be stored in at least one of the following storage manners: the replication redundancy processing manner and the erasure encoding and decoding processing manner, then the data to be stored is stored in the storage manner corresponding to the storage strategy identifier, that is, the storage manner for the data to be stored can be set according to different needs or actual conditions, and for example, the data to be stored may be stored in the replication redundancy processing manner when a storage space is sufficient, and the data to be stored may be stored in the erasure encoding and decoding processing manner when a utilization rate of the storage space is required to be increased, so that the security and reliability of the data are ensured, meanwhile, the redundancy of the data is reduced, and the utilization rate of the storage space is increased. Therefore, the storage manner for the data to be stored may be set according to different needs or actual conditions to improve data redundancy implementation flexibility.

### Brief Description of the Drawings

The drawings are described here to provide further understanding of the present invention, and form a part of the present invention. The schematic embodiments and description of the present invention are adopted to explain the present invention, and do not form improper limits to the present invention. In the drawings:
Fig. 1 is a flowchart of a method for implementing data redundancy according to an embodiment of the present invention;
Fig. 2 is a structure diagram of a device for implementing data redundancy according to an embodiment of the present invention;
Fig. 3 is a structure diagram of a storage component according to an embodiment of the present invention;
Fig. 4 is a structure diagram of another device for implementing data redundancy according to an embodiment of the present invention;
Fig. 5 is a structure diagram of a system for implementing data redundancy according to an embodiment of the present invention;
Fig. 6 is a flowchart of erasure coding on data under a condition that an erasure encoding and decoding processing manner is adopted according to an embodiment of the present invention;
Fig. 7 is a flowchart of erasure decoding on data under a condition that an erasure encoding and decoding processing manner is adopted according to an embodiment of the present invention;
Fig. 8 is a flowchart of file writing under a condition that an erasure encoding and decoding processing manner is adopted according to an embodiment of the present invention; and
Fig. 9 is a flowchart of file reading under a condition that an erasure encoding and decoding processing manner is adopted according to an embodiment of the present invention.

### Detailed Description of the Embodiments

The present invention is described below with reference to the drawings and embodiments in detail. It is important to note that the embodiments of the present invention and the characteristics in the embodiments can be combined under the condition of no conflicts.

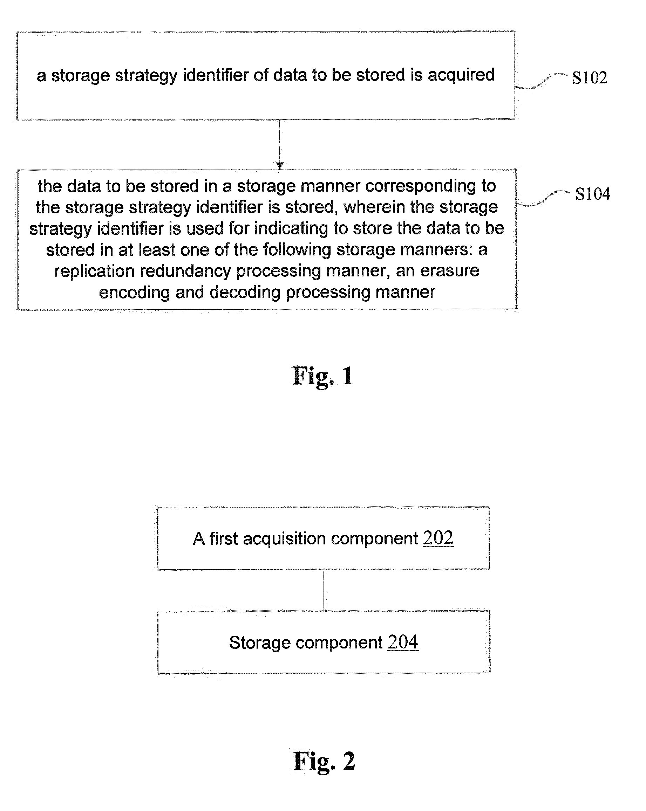

An embodiment provides a method for implementing data redundancy, and as shown in Fig. 1, the method for implementing data redundancy includes Step 102 to Step 104.

Step 102: a storage strategy identifier of data to be stored is acquired.

Step 104: the data to be stored in a storage manner corresponding to the storage strategy identifier is stored, wherein the storage strategy identifier is used for indicating to store the data to be stored in at least one of the following storage manners: a replication redundancy processing manner, an erasure encoding and decoding processing manner.

By the steps, the storage strategy identifier of the data to be stored is acquired at first, and is used for indicating to store the data to be stored in at least one of the following storage manners: the replication redundancy processing manner and the erasure encoding and decoding processing manner, then the data to be stored is stored in the storage manner corresponding to the storage strategy identifier, that is, the storage manner for the data to be stored may be set according to different needs or actual conditions, and for example, the data to be stored may be stored in the replication redundancy processing manner when a storage space is sufficient, and the data to be stored may be stored in the erasure encoding and decoding processing manner when a utilization rate of the storage space is required to be increased, so that the security and reliability of the data are ensured, meanwhile, the redundancy of the data is reduced, and the utilization rate of the storage space is increased. Therefore, the storage manner for the data to be stored may be set according to different needs or actual conditions to improve data redundancy implementation flexibility.

Preferably, the method for implementing data redundancy may be applied to a DFS to increase a storage space utilization rate of the DFS and also ensure the reliability of the stored data. Whether replication redundancy processing or erasure encoding and decoding processing is adopted for the data to be stored is determined according to a configuration environment and needs. A replication redundancy technology refers to the storage of multiple complete copies of the data to be stored. Erasure encoding and decoding refers to that the data to be stored is encoded according to an EC algorithm for the formation of a plurality of fragments. After the system discovers that some of fragments are damaged, data may be correctly recovered by carrying out a decoding algorithm on the encoded data, thereby avoiding the data corruption of the system. When the storage space is sufficient, a replication redundancy mechanism may be adopted, and only one replication is required to be normal when the data is abnormal; and when the utilization rate of the storage space is required to be increased, the erasure encoding and decoding manner may be selected to improve the reliability of the data. Therefore, a novel configurable implementation scheme applied to the data redundancy of the DFS is presented by the method for implementing data redundancy.

Compared with a conventional single-complete replication method for implementing data redundancy, the method for implementing data redundancy has the advantages that a complete replication manner may be adopted when the storage space is sufficient; and the EC algorithm may also be adopted for the encoding of the data to be stored under the same storage space, and such a storage manner may achieve redundancy lower than that of the complete replication manner. Therefore, relative to a storage manner of achieving the reliability of the data by simply adopting the replication mechanism, the EC-algorithm-based method for implementing data redundancy may effectively increase the utilization rate of the storage space under the same data reliability. The data to be stored is stored by virtue of corresponding redundancy schemes according to different redundancy scheme configurations, so that the practicability of a storage system is greatly improved. The scheme is preferably applied to a DFS with an FLR.

In Step 104, the data to be stored may be stored in the erasure encoding and decoding processing storage manner by steps as follows. For example, storing the data to be stored in the erasure encoding and decoding processing storage manner includes: encoding ratio information for the erasure coding of the data to be stored is acquired from the FLR, wherein the encoding ratio information includes: the number N of chunks obtained by dividing the data of each page of the data to be stored and the number M of redundant chunks obtained after the encoding of the chunks of each page, and N and M are natural numbers; the data of each page of the data to be stored is divided into the N chunks according to the encoding ratio information and a size of the data to be stored, the N chunks as a group is coded with EC, and generating M redundant chunks for each group; and under the condition that the encoding of all the chunks of a certain page is finished, the encoded chunks of the page is stored into a database.

Preferably, a value of N and a value of M may be set according to different needs, and for example, the value of M may be set to be higher and the value of N may be set to be lower under the condition that the storage space is sufficient, and the value of M may be set to be lower and the value of N may be set to be higher under the condition that the size of the data to be stored is larger and/or the utilization rate of the storage space is required to be increased, that is, the value of N and the value of M may be properly set according to different needs and/or actual conditions.

In an implementation process, the encoded chunks of the page may be stored into the database by the following steps in the preferred embodiment. For example, under the condition that the encoding of the chunks in the page is not finished, N+M caches is applied, and the encoded chunks is stored in the applied caches; under the condition that the encoding of all the chunks in the page is finished, a request message of applying for N+M storage nodes is transmitted to the database; a reply message in response to the request message is received, wherein the reply message includes: node information of the N+M storage nodes and location information of the N+M storage nodes; and the N+M chunks obtained after the encoding of the chunks of each page is stored into the N+M applied storage nodes according to the node information and the location information respectively.

In order to improve the reliability of the data, in the preferred embodiment, storing the N+M chunks obtained after the encoding of the chunks of each page into the N+M applied storage nodes according to the node information and the location information respectively includes: under the condition that more than M chunks in the encoded chunks of each page are detected to fail to be stored, a storage failure alarm or notice is transmitted. That is, under the condition that more than M chunks are detected to fail to be stored, a storage (writing) failure alarm or notice is transmitted to indicate that the data to be stored fails to be stored.

In order to improve the reliability of the data, under the condition that some chunks are detected to fail to be stored, storing the N+M chunks obtained after the encoding of the chunks of each page into the N+M applied storage nodes according to the node information and the location information respectively includes: under the condition that at most M chunks in the encoded chunks of each page are detected to fail to be stored, the chunks failing to be stored are restored into the storage nodes corresponding to the chunks failing to be stored, or the chunks failing to be stored are restored into newly-applied storage nodes.

In order to meet requirements of different application scenarios, in the preferred embodiment, after storing the data to be stored in the storage manner corresponding to the storage strategy identifier, the method for implementing data redundancy further includes: reading information of data to be read is acquired, wherein the reading information includes: a storage strategy identifier of the data to be read; and the data to be read is read in a corresponding reading manner according to the storage strategy identifier of the data to be read, wherein the storage strategy identifier of the data to be read is used for indicating that the storage manner for the data to be read adopts at least one of: the replication redundancy processing manner and the erasure encoding and decoding processing manner. That is, after the data is stored, the data may be read according to the storage manner, and the encoded data is decoded to be recovered.

In a preferred embodiment, the data to be read may be read in the erasure encoding and decoding processing manner by the following steps. For example, reading the data to be read in the corresponding reading manner according to the storage strategy identifier of the data to be read includes: under the condition that the storage manner for the data to be read adopts the erasure encoding and decoding processing manner, storage information corresponding to N+M encoded chunks of each page of the data to be read is acquired, wherein the storage information includes: storage node information of N+M storage nodes and location information of the N+M storage nodes, and N and M are natural numbers; the N+M encoded chunks of each page are read from the N+M storage nodes according to the storage information; and sequentially N chunks are selected from the N+M read chunks for decoding with the EC so as to obtain the data of each page.

In the preferred embodiment, a device for implementing data redundancy is provided, and as shown in Fig. 2, the device for implementing data redundancy includes: a first acquisition component 202 configured to acquire a storage strategy identifier of data to be stored; and a storage component 204 connected to the first acquisition component 202 and configured to store the data to be stored in a storage manner corresponding to the storage strategy identifier, wherein the storage strategy identifier is used for indicating the data to be stored is stored in at least one of the following storage manners: a replication redundancy processing manner and an erasure encoding and decoding processing manner.

In a preferred embodiment, the first acquisition component 202 acquires the storage strategy identifier of the data to be stored at first, the storage strategy identifier being used for indicating the data to be stored is stored in at least one of the following storage manners: the replication redundancy processing manner and the erasure encoding and decoding processing manner. The storage component 204 stores the data to be stored in the storage manner corresponding to the storage strategy identifier, that is, the storage manner for the data to be stored may be set according to different needs or actual conditions. For example, the data to be stored may be stored in the replication redundancy processing manner when a storage space is sufficient, and the data to be stored may be stored in the erasure encoding and decoding processing manner when a utilization rate of the storage space is required to be increased, so that the security and reliability of the data are ensured, meanwhile, the redundancy of the data is reduced, and the utilization rate of the storage space is increased. Therefore, the storage manner for the data to be stored may be set according to different needs or actual conditions to improve data redundancy implementation flexibility.

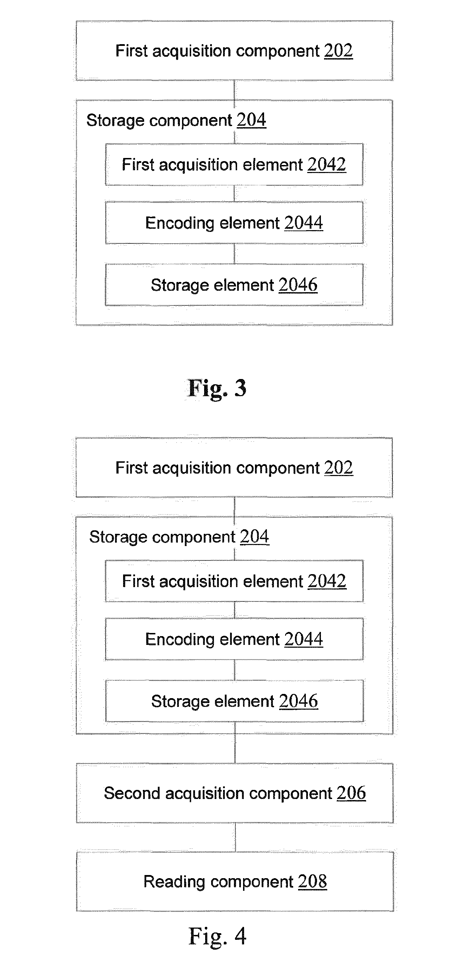

In a preferred embodiment, as shown in Fig. 3, the storage component 204 includes: a first acquisition element 2042 configured to acquire encoding ratio information for encoding the data to be stored with EC from an FLR, wherein the encoding ratio information includes: the number N of chunks obtained by dividing the data of each page of the data to be stored and the number M of redundant chunks obtained after the encoding of the chunks of each page, and N and M are natural numbers; an encoding element 2044 connected to the first acquisition element 2042 and configured to divide the data of each page of the data to be stored into the N chunks according to the encoding ratio information and a size of the data to be stored, to code the N chunks as a group with EC, and generate M redundant chunks for each group; and a storage element 2046 connected to the encoding element 2044 and configured to, under the condition that the encoding of all the chunks of a page is finished, store the encoded chunks of the page into a database.

In a preferred embodiment, the storage element 2046 further includes: a transmission sub-element configured to transmit a request message of applying for N+M storage nodes to the database; a receiving sub-element connected to the transmission sub-element and configured to receive a reply message in response to the request message, wherein the reply message includes: node information of the N+M storage nodes and location information of the N+M storage nodes; and a first storage sub-element connected to the receiving sub-element and configured to store the N+M chunks obtained after the encoding of the chunks of each page into the N+M applied storage nodes according to the node information and the location information respectively.

In order to improve the reliability of the data, under the condition that some chunks are detected to fail to be stored, in a preferred embodiment, the storage element 2046 further includes: a transmission sub-element configured to, under the condition that more than M chunks in the encoded chunks of each page are detected to fail to be stored, transmit a storage failure alarm or notice; and a second storage sub-element configured to, under the condition that at most M chunks in the encoded chunks of each page are detected to fail to be stored, restore the chunks failing to be stored into the storage nodes corresponding to the chunks failing to be stored, or restore the chunks failing to be stored into newly-applied storage nodes.

In order to meet requirements of different application scenario, in a preferred embodiment, as shown in Fig. 4, the device for implementing data redundancy further includes: a second acquisition component 206 configured to acquire reading information of data to be read, wherein the reading information includes: a storage strategy identifier of the data to be read; and a reading component 208 connected to the second acquisition component 206 and configured to read the data to be read in a corresponding reading manner according to the storage strategy identifier of the data to be read, wherein the storage strategy identifier of the data to be read is configured to indicate that the storage manner for the data to be read adopts at least one of: the replication redundancy processing manner and the erasure encoding and decoding processing manner.

In a preferred embodiment, the reading component 208 may include: a second acquisition element configured to, under the condition that the storage manner for the data to be read adopts the erasure encoding and decoding processing manner, acquire storage information corresponding to N+M encoded chunks of each page of the data to be read, wherein the storage information includes: storage node information of N+M storage nodes and location information of the N+M storage nodes, and N and M are natural numbers; a reading element connected to the second acquisition element and configured to read the N+M encoded chunks of each page from the N+M storage nodes according to the storage information; and a decoding element connected to the reading element and configured to sequentially select N chunks from the N+M read chunks for decoding with EC so as to obtain the data of each page.

Preferably, the device for implementing data redundancy may be preferably applied to a DFS with an FLR.

Each preferred embodiment is described below with reference to the drawings in detail.

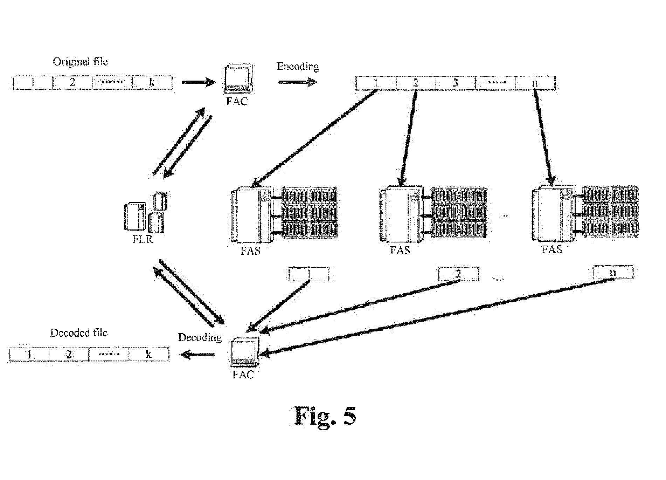

Fig. 5 is a structure diagram of a system for implementing data redundancy according to an embodiment of the present invention, and as shown in Fig. 5, the system for implementing data redundancy includes: a File Access Client (FAC), an FLR, a File Access Servers (FAS), a DFS and a storage medium. The FAC is responsible for providing interface calling service similar to a standard file system for an application oriented to the file system and also serving to acquire a data storage strategy from an FLR side to implement a corresponding data replication storage or EC encoding and decoding algorithm as an actual EC encoding and decoding side.

The FLR is responsible for managing metadata information such as filenames and chunks of all files in the file system; and providing operation such as metadata writing and query for the FAC, wherein a file storage attribute flag bit is added to identify a storage strategy of a current file on the basis of original metadata to realize an EC function. When a file is opened, the FLR acquires the flag bit from a database, and different processing flows are adopted for different storage attributes. When the file is stored by virtue of an EC storage strategy, the FLR is required to acquire an EC encoding ratio from the database to further determine the number of replications of the chunks and return the number of the replications of the chunks to the FAC.

The FAS is responsible for interacting with a storage medium in the file system to perform actual chunk read-write operation; reading data from the storage medium in response to a data read-write request of the FAC, and returning the read data to the FAC; and reading data from the FAC, and writing the read data into the storage medium.

The storage medium is usually an ordinary Small Computer System Interface (SCSI) disk or a Serial Advanced Technology Attachment (SATA) disk.

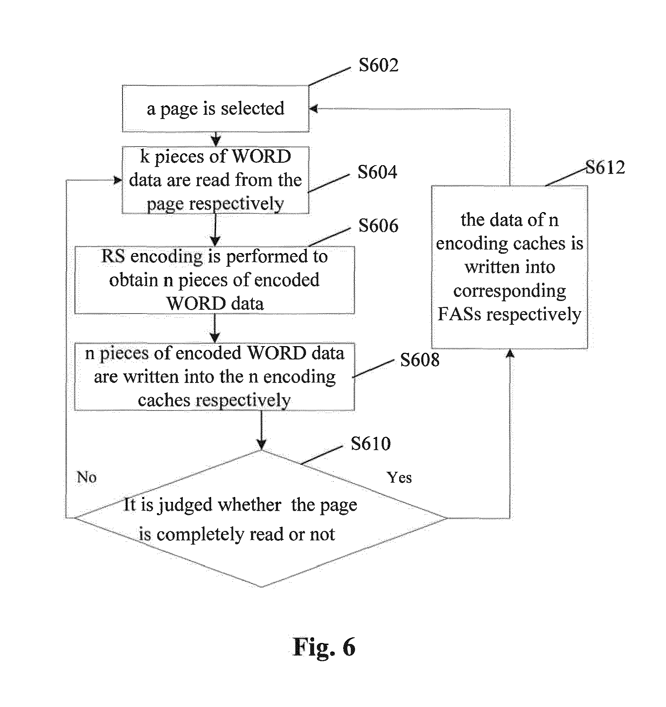

A DFS is taken as an example in the preferred embodiment, and based on the system for implementing data redundancy, the FAC of the conventional DFS manages the files by taking a page as a unit. When the FAC writes files into the FASs, operation is finished also by taking a page as a unit. In order to support the EC, the FAC is required to perform Reed-solomon (RS) encoding on pages. Then encoded data is written into the FAS. Fig. 6 is a flowchart of erasure coding on data under a condition that an erasure encoding and decoding processing manner is adopted according to an embodiment of the present invention, and as shown in Fig. 6, the flow may include the following steps.

Step 602: an FAC selects a page (equivalent to the data to be stored).

Step 604: the FAC reads K pieces of WORD data from the page.

Step 606: the data in the page is encoded in an RS manner to obtain N pieces of encoded WORD data.

Step 608: the N pieces of encoded WORD data is written into N encoding caches respectively.

Step 610: it is judged whether the page is completely read or not. Turn to Step 612 if the page is completely read, otherwise turn to Step 604; and

Step 612: The data of the N encoding caches is written into corresponding FASs respectively, and the Step 602 is performed.

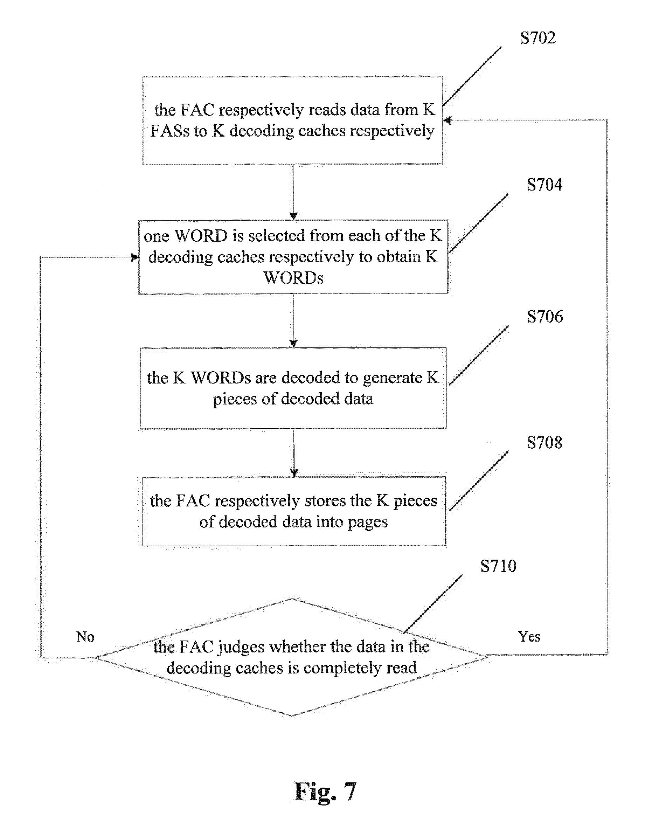

Fig. 7 is a flowchart of erasure decoding on data under a condition that an erasure encoding and decoding processing manner is adopted according to an embodiment of the present invention, and as shown in Fig. 7, the flow may include the following steps.

Step 702: an FAC sequentially reads data from K FASs and writes same into K decoding caches respectively.

Step 704: the FAC sequentially selects WORD data, which is totally K pieces of WORD data, from the K decoding caches respectively.

Step 706: the FAC decodes the K pieces of WORD data to generate K pieces of decoded data.

Step 708: the FAC sequentially stores the K pieces of decoded data into pages.

Step 710: the FAC judges whether the data in the decoding caches is completely read or not. Turn to Step 702 if the data in the decoding caches is completely read, otherwise turn to Step 704.

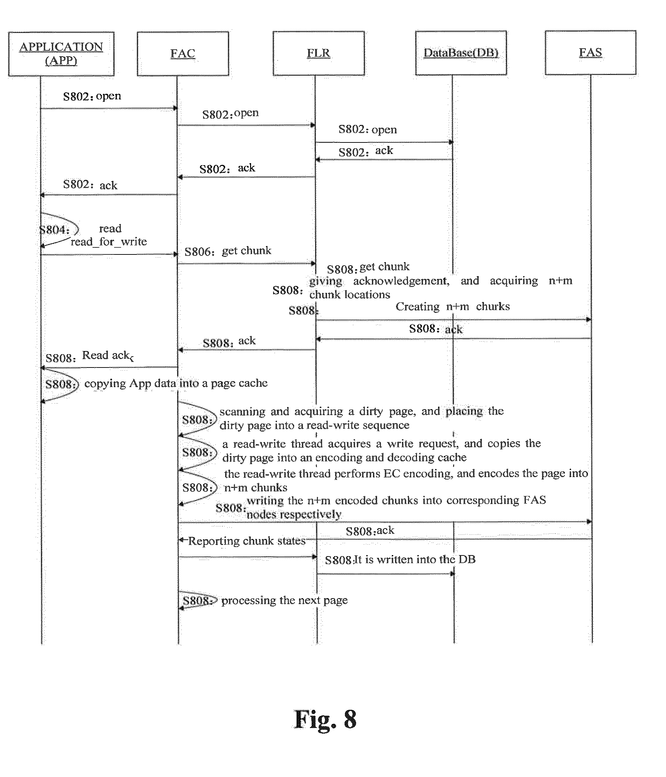

In the preferred embodiment, under the condition that the storage strategy identifier indicates the adoption of an erasure encoding and decoding strategy, the FAC is adopted as an erasure encoding and decoding implementation side, and the encoded redundant data is written into the FASs; and when some of data fragments are abnormal, the FAC reads the other fragments from the FASs to implement decoding and obtain original data. Fig. 8 is a flowchart of file writing under a condition that an erasure encoding and decoding processing manner is adopted according to an embodiment of the present invention, and as shown in Fig. 8, the flow may include the following steps.

Step 802: before a write interface is called, the FAC is required to open the file (equivalent to the data to be stored) to acquire a File Descriptor (FD) and acquire an identifier, which is indicating that whether a redundancy mechanism (equivalent to the storage strategy identifier) for chunks of the file is a double-replication redundancy mechanism or an EC redundancy mechanism, from the database through the FLR.

Step 804: the FAC judges the storage strategy identifier in the write interface, and calls a corresponding strategy flow.

Step 806: the FAC divides pages into chunks (the size of each chunk may be 1 byte or any other, may be set according to actual values of N and M and an actual page size, and may not be changed after being set) by taking a page as a unit. Every N chunks as a group are encoded with EC, and the coded chunks are stored into N+M newly-applied caches until the coding of all the chunks in one page is finished, and then encoded data is written into the next page.

Step 808: the FAC is required to apply for N+M storage nodes to the database and acquire storage node information and location information of the N+M storage nodes before writing the encoded chunks into the FASs, and then writes the N+M encoded chunks into the acquired FASs respectively.

In step 810, if there is a node failing to be written, the FAC tries to rewrite (there are two tries: one is to try to continue writing the encoded chunks into the node, and the other is to try to apply for other nodes for writing the encoded chunks); if there are more than M nodes failing to be written, the page fails to be written, that is, the file fails to be written, and a write failure alarm or notice is transmitted; and if there are only less than M nodes failing to be written, the FAC retries, or neglects the failure, and the data maybe decoded to be recovered subsequently or during reading.

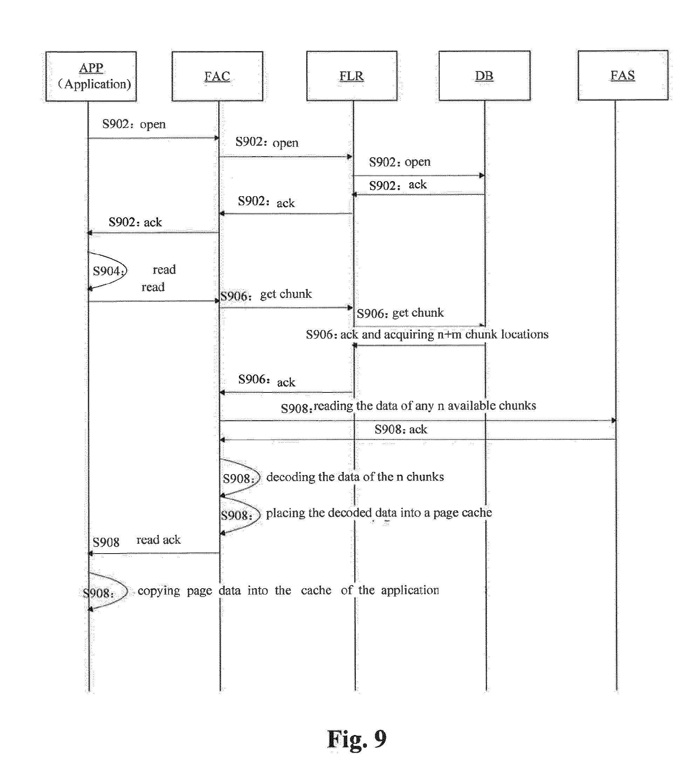

Fig. 9 is a flowchart of file reading under a condition an erasure encoding and decoding processing manner is adopted according to an embodiment of the present invention, and as shown in Fig. 9, the flow may include the following steps.

Step 902: the FAC opens a file (equivalent to the data to be stored), and acquires a strategy identifier from a database through the FAR.

Step 904: the FAC judges a redundancy strategy indicated by the identifier, and enters a corresponding flow.

Step 906: the FAC reads pages one by one, and when a page is read, the FAC is required to acquire storage node information of N+M storage nodes for storing chunks of the page.

Step 908: the N+M chunks are read into the FAC from the N+M storage nodes, and N chunks are sequentially selected from the chunks to be decoded to recover the first group of N actual chunks in the page according to the sizes of the chunks until the whole page is completely recovered.

In Step 908, as long as not more than M nodes fail to be read, the actual data of the page may be completely recovered; and once more than M nodes fail to be read, the page fails to be read.

From the above, it can be seen that the embodiment of the present invention has the technical effects that: the storage strategy identifier of the data to be stored is acquired at first, wherein the storage strategy identifier is used for indicating the data to be stored is stored in at least one of the following storage manners: the replication redundancy processing manner and the erasure encoding and decoding processing manner, then the data to be stored is stored in the storage manner corresponding to the storage strategy identifier, that is, the storage manner for the data to be stored may be set according to different needs or actual conditions. For example, the data to be stored may be stored in the replication redundancy processing manner when a storage space is sufficient, and the data to be stored may be stored in the erasure encoding and decoding processing manner when a utilization rate of the storage space is required to be increased, so that the security and reliability of the data are ensured, meanwhile, the redundancy of the data is reduced, and the utilization rate of the storage space is increased. Therefore, the storage manner for the data to be stored may be set according to different needs or actual conditions to improve data redundancy implementation flexibility.

### Industrial Applicability

According to the embodiments of the present invention, the storage manner for the data to be stored may be set according to different needs or actual conditions, and for example, the data to be stored may be stored in the replication redundancy processing manner when a storage space is sufficient, and the data to be stored may be stored in the erasure encoding and decoding processing manner when a utilization rate of the storage space is required to be increased, so that the security and reliability of the data are ensured, meanwhile, the redundancy of the data is reduced, and the utilization rate of the storage space is increased. Therefore, the storage manner for the data to be stored may be set according to different needs or actual conditions to improve data redundancy implementation flexibility and achieve high industrial applicability.

Obviously, those skilled in the art should know that each component or step of the embodiment of the present invention can be implemented by a universal computing device, and the components or steps can be concentrated on a single computing device or distributed on a network formed by a plurality of computing devices, and can optionally be implemented by programmable codes executable for the computing devices, so that the components or steps can be stored in a storage device for execution with the computing devices, or can form each integrated circuit component, or multiple components or steps therein can form a single integrated circuit component for implementation. As a consequence, the present invention is not limited to any specific hardware and software combination.

The above is only the preferred embodiment of the present invention and not intended to limit the present invention, and for those skilled in the art, the present invention can have various modifications and variations. Any modifications, equivalent replacements, improvements and the like within the spirit and principle of the present invention shall fall within the scope of protection of the present invention.

## Claims

1. A method for implementing data redundancy, **characterized by** comprising:
acquiring a storage strategy identifier of data to be stored; and
storing the data to be stored in a storage manner corresponding to the storage strategy identifier, wherein the storage strategy identifier is used for indicating to store the data to be stored in at least one of the following storage manners: a replication redundancy processing manner, an erasure encoding and decoding processing manner.

2. The method according to claim 1, **characterized in that** storing the data to be stored in the erasure encoding and decoding processing storage manner comprises:
acquiring encoding ratio information, which is for encoding the data to be stored with Erasure Code (EC), from a File Location Register (FLR), wherein the encoding ratio information comprises: the number N of chunks obtained by dividing the data of each page of the data to be stored and the number M of redundant chunks obtained after an encoding of the chunks of each page, and N and M are natural numbers;
dividing the data of each page of the data to be stored into the N chunks according to the encoding ratio information and a size of the data to be stored, performing encoding with the EC on the N chunks as a group, and generating M redundant chunks for each group; and
under a condition that the encoding of all the chunks of a page is finished, storing the encoded chunks of the page into a database.

3. The method according to claim 2, **characterized in that** storing the encoded chunks of the page into the database comprises:
transmitting a request message of applying for N+M storage nodes to the database;
receiving a reply message in response to the request message, wherein the reply message comprises: node information of the N+M storage nodes and location information of the N+M storage nodes; and
storing the N+M chunks obtained after the encoding of the chunks of each page into the N+M applied storage nodes according to the node information and the location information respectively.

4. The method according to claim 3, **characterized in that** storing the N+M chunks obtained after the encoding of the chunks of each page into the N+M applied storage nodes according to the node information and the location information respectively comprises:
under a condition that more than M chunks in the encoded chunks of each page are detected to fail to be stored, transmitting a storage failure alarm or notice.

5. The method according to claim 3, **characterized in that** storing the N+M chunks obtained after the encoding of the chunks of each page into the N+M applied storage nodes according to the node information and the location information respectively comprises:
under a condition that at most M chunks in the encoded chunks of each page are detected to fail to be stored, restoring the chunks failing to be stored into storage nodes corresponding to the chunks failing to be stored, or restoring the chunks failing to be stored into newly-applied storage nodes.

6. The method according to claim 1, after storing the data to be stored in the storage manner corresponding to the storage strategy identifier, further comprising:
acquiring reading information of data to be read, wherein the reading information comprises: a storage strategy identifier of the data to be read; and
reading data to be read in a corresponding reading manner according to the storage strategy identifier of the data to be read, wherein the storage strategy identifier of the data to be read is used for indicating that the data to be read is stored in at least one of the following storage manners: the replication redundancy processing manner and the erasure encoding and decoding processing manner.

7. The method according to claim 6, **characterized in that** reading the data to be read in the corresponding reading manner according to the storage strategy identifier of the data to be read comprises:
under a condition that the storage manner for the data to be read adopts the erasure encoding and decoding processing manner, acquiring storage information corresponding to N+M encoded chunks of each page of the data to be read, wherein the storage information comprises: storage node information of N+M storage nodes and location information of the N+M storage nodes, and N and M are natural numbers;
reading the N+M encoded chunks of each page from the N+M storage nodes according to the storage information; and
sequentially selecting N chunks from the N+M read chunks for decoding with the EC, and performing recovery to obtain the data of each page.

8. A device for implementing data redundancy, **characterized by** comprising:
a first acquisition component configured to acquire a storage strategy identifier of data to be stored; and
a storage component configured to store the data to be stored in a storage manner corresponding to the storage strategy identifier, wherein the storage strategy identifier is used for indicating to store the data to be stored in at least one of the following storage manners: a replication redundancy processing manner, an erasure encoding and decoding processing manner.

9. The device according to claim 8, **characterized in that** the storage component comprises:
an acquisition element configured to acquire encoding ratio information, which is for encoding the data to be stored with Erasure Code (EC), from a File Location Register (FLR), wherein the encoding ratio information comprises: the number N of chunks obtained by dividing the data of each page of the data to be stored and the number M of redundant chunks obtained after an encoding of the chunks of each page, and N and M are natural numbers;
an encoding element configured to divide the data of each page of the data to be stored into the N chunks according to the encoding ratio information and a size of the data to be stored, perform encoding with the EC on the N chunks as a group, and generate M redundant chunks for each group; and
a storage element configured to, under a condition that the encoding of all the chunks of a page is finished, store the encoded chunks of the page into a database.

10. The device according to claim 8, **characterized by** further comprising:
a second acquisition component configured to acquire reading information of data to be read, wherein the reading information comprises: a storage strategy identifier of the data to be read; and
a reading component configured to read the data to be read in a corresponding reading manner according to the storage strategy identifier of the data to be read, wherein the storage strategy identifier of the data to be read is used for indicating that the data to be read is stored in at least one of the following manners: the replication redundancy processing manner and the erasure encoding and decoding processing manner.
